# EUROPEAN PATENT APPLICATION

(11) **EP 4 835 435 A1**
(43) Date of publication of application: **04.11.2026**
(21) Application number: 25173184.0
(22) Date of filing: 29.04.2025
(51) Int. Cl.: G01N 1/32, H01J 37/305, G01N 1/28

(54) **CONTROL SYSTEM, METHOD, AND COMPUTER PROGRAM FOR AN ION MILLING SYSTEM, ION MILLING SYSTEM**

(71) Applicant: Leica Mikrosysteme GmbH, 1170 Wien (AT)
(72) Inventor: WINKLER, Konrad, 1170 Wien (AT); KATZENGRUBER, Matthias, 1170 Wien (AT); AOUDJIT, Slimane, 1170 Wien (AT)
(74) Representative: 2SPL Patentanwälte PartG mbB

(57) **Abstract**

Examples relate to a control system, method, and computer program for an ion milling system, and to an ion milling system comprising such a control system. The control system is configured to obtain image data of an imaging device of the ion milling system, the image data showing a sample (10) to be milled using ions emitted by at least one ion emitter (130) of the ion milling system, generate a view of the sample based on the image data, provide a user interface for a display device, the user interface comprising the view of the sample, with the user interface comprising an input mechanism for selecting a portion of the sample using a pointing device, obtain a user input related to the selection (40) of the portion of the sample, control an area to be milled using the ions emitted by at least one ion emitter based on the portion of the sample selected by the user.

## Description

### Technical field

Examples relate to a control system, method, and computer program for an ion milling system, and to an ion milling system that comprises such a control system.

### Background

In an ion mill, samples are processed using an ion beam, such as an argon ion beam, to create a flawless surface for subsequent analysis with an electron microscope. For this purpose, the sample is mounted on a sample stage opposite the ion source. A mask shields part of the ion beam. The ion source, mask, and sample are adjusted in relation to one another so that a good result can be achieved by irradiating the sample with ions.

During alignment, the positions of the sample, mask, and ion source are adjusted relative to each other using an optical microscope. In some ion mills, the user then defines how the sample is to be moved in front of the ion beam by defining parameters of a motorized sample stage. The user also defines parameters of the ion beam and the processing time to determine the depth of processing. The above process requires expert knowledge and experience and generally needs to be performed by a skilled operator.

There may be a desire to provide an improved mechanism for setting up a sample for ion milling that requires less skill and experience on the part of the operator.

### Summary

This desire is addressed by the subject matter of the independent claims.

Various examples of the present disclosure are based on the finding that the combination of a high-resolution imaging device and a highly precise motorized sample stage can be used to automatically determine the parameters to be used for controlling the area to be milled. he proposed concept provides a user interface that enables users to visually select a portion of the sample to be milled using the ion beam. By translating the user's selection into corresponding parameters for placing and/or moving the sample (and mask) relative to the ion beam and/or for irradiating the sample, an area to be milled can be controlled based on the selection performed via the user interface. This way, less experienced users are enabled to precisely control the area to be milled.

Some aspects of the present disclosure relate to a control system for an ion milling system. The control system comprises one or more processors and one or more storage devices. The control system is configured to obtain image data of (e.g., from) an imaging device of the ion milling system. The image data shows a sample to be milled using ions emitted by at least one ion emitter of the ion milling system. The control system is configured to generate a view of the sample based on the image data. The control system is configured to provide a user interface for a display device. The user interface comprises the view of the sample. The user interface comprises an input mechanism for selecting a portion of the sample using a pointing device. The control system is configured to obtain a user input related to the selection of the portion of the sample. The control system is configured to control an area to be milled using the ions emitted by at least one ion emitter based on the portion of the sample selected by the user. By providing the user interface with the view of the sample and the input mechanism, the user is enabled to select the area of the sample to be milled. This selection can then be used to control the area to be milled, so that less experienced users are enabled to precisely control the area to be milled.

In most cases, a geometrically restricted selection, for example, a rectangular selection, is useful for facilitating the selection of the area of the sample. For example, the control system may be configured to provide the user interface with an input mechanism that is operable for selecting a rectangular portion of the sample using the pointing device. Rectangular portions of the sample can be easily selected by defining two corners of the area while providing enough flexibility for common types of samples.

A rectangular selection is an example of a selection that encloses a two-dimensional portion of the view of the sample. More generally, the control system may be configured to provide the user interface with an input mechanism that is operable for selecting an enclosed two-dimensional portion of the view of the sample. Beyond rectangular selection, arbitrary areas may be selectable by the user, which may improve the flexibility of the selection mechanism.

In the proposed concept, the area to be milled is selected by the user via the user interface. This selection is translated into corresponding parameters for the components of the ion milling system in order to perform the ion milling across the selected area. To target the selected area with the ion emitter, the relative position and/or orientation of the ion emitter(s) and the sample is adjusted, for example, using a mechanical positioning system, such as a motorized sample stage or a targeting mechanism of the ion emitter(s). Accordingly, the control system may be configured to control a mechanical positioning system configured to adjust at least one of a lateral position, vertical position, or orientation of the at least one ion emitter or of a sample stage hosting the sample to control the area to be milled. This way, the relative position of the sample and the ion emitter(s) can be adjusted so that the ion beam irradiates the selected area of the sample.

In general, the imaging device may be precisely aligned with the sample, e.g., with the sample stage, such that pixels of the image data can be matched to real-world coordinates with respect to the sample stage. This relationship between the pixels of the image data and the real-world coordinates can be used to target the area of the sample. For example, the control system may be configured to control the mechanical positioning system based on a pre-defined relationship between pixels of the image data and a corresponding lateral position, vertical position and/or orientation of the at least one ion emitter or of the sample stage. For example, for a given position, orientation, and width of the ion beam relative to the coordinate system of the ion milling system, the real-world coordinates that are irradiated by the ion beam are known. The pre-defined relationship can be used to move the sample to a position at which a portion of the sample being shown by a pixel is irradiated by the ion beam. Similarly, for a given position and orientation of the sample in the ion milling system, the position and/or orientation of the ion emitter can be changed such that the portion of the sample being shown by a pixel is irradiated by the ion beam.

In many cases, the width of the ion beam may be insufficient for milling the entire selected area at once. Moreover, to avoid local deformation due to heat, care may be taken not to irradiate the same point of the sample for too long. To address this, the sample may be irradiated according to a milling path, to evenly irradiate the selected area. In other words, the control system may be configured to determine a milling path based on the portion of the sample selected by the user. The milling path indicates a sequence of adjustments to the lateral position, vertical position, and/or orientation of the at least one ion emitter or sample stage based on the portion of the sample selected by the user.

When an argon ion beam hits a sample, the distribution of ions typically follows a Gaussian profile, i.e., the concentration of ions is highest at the center and gradually decreases toward the edges of the beam spot. This distribution is influenced by factors such as beam energy, focusing optics, and the angle of incidence. The distribution of ions affects the amount of material that is removed by the ion beam and may thus be taken into account when irradiating the sample. For example, the control system may be configured to determine the milling path based on a spatial distribution of ions within the ion beam and/or based on a kinetic energy of the ions emitted by the ion emitter. In this way, it may be ensured that a desired milling depth is the same across the area.

In addition to the area selected, the depth to be milled is also relevant for determining the milling path. For example, the control system may be configured to determine the milling path further based on a desired depth of material to be removed by the ion milling. This way, the milling path may be selected such that material is equally removed from the respective portions of the area to be milled according to the desired depth.

In some examples, the exact effect of the ion beam on the material may be hard to predict. Moreover, minor misalignments between the ion beam(s) and the sample may occur over time. To account for these ambiguities, the progress of the ion milling may be checked by the control system and used to adjust (or maintain, if the progress is as expected) the milling path. Accordingly, the control system may be configured to obtain further image data of (e.g., from) the imaging device, the image data showing the progress of the ion milling of the sample. The control system may be configured to maintain or adjust the milling path based on the progress of the ion milling of the sample shown in the further image data.

In ion milling systems, the sample is partially shielded by a mask, for example, to avoid damaging some portions of the sample, the sample holder, and/or the sample stage with the ion beam. For example, the image data further shows the mask for shielding a further portion of the sample, with the user interface comprising a view of the mask and the sample. This way, the user can check that the correct portion of the sample is exposed to the ion beam. While the mask's purpose is to shield the sample from the ion beam, its lifespan can be increased by minimizing irradiation. Therefore, the control system may be configured to exclude the mask from the area to be milled. However, due to the Gaussian distribution of the ions in the ion beam, some irradiation is going to occur at the mask.

There are various user interface modalities that can be used to select the area to be milled. For example, the control system may be configured to provide the user interface for a touch screen of the ion milling system, and to obtain the user input via the touch screen. This way, no peripherals may be required, allowing less space to be required for using the ion milling system.

Alternatively, or additionally, the control system may be configured to provide the user interface via a computer system of the ion milling system, and to obtain the user input via a mouse, trackpad or trackball of the computer system. Mice, trackpads or trackballs enable a highly precise selection of the area to be milled.

In some examples, the selection does not have to occur at the ion milling system. Instead, the user interface may be provided to a remote device, e.g., as a web application. For example, the control system may be configured to provide the user interface for a client device via a computer network, and to obtain the user input via the client device. This way, a larger, existing screen may be used to perform the selection.

Another aspect of the present disclosure relates to an ion milling system comprising the above-described control system, an imaging device, and at least one ion emitter.

For example, as outlined above, the ion milling system may comprise a mechanical positioning system configured to adjust at least one of the lateral position, vertical position, or orientation of the at least one ion emitter or of a sample stage hosting the sample. Using the mechanical positioning system, the relative positions of the sample and the ion emitter(s) can be adjusted such that the ion beam irradiates the selected area of the sample.

Some aspects of the present disclosure relate to a corresponding method for controlling an ion milling system. The method comprises obtaining image data of an imaging device of the ion milling system. The image data shows a sample to be milled using ions emitted by at least one ion emitter of the ion milling system. The method comprises generating a view of the sample based on the image data. The method comprises providing a user interface for a display device. The user interface comprises the view of the sample. The user interface comprises an input mechanism for selecting a portion of the sample using a pointing device. The method comprises obtaining a user input related to the selection of the portion of the sample. The method comprises controlling an area to be milled using the ions emitted by at least one ion emitter based on the portion of the sample selected by the user.

Another aspect of the present disclosure relates to a computer program having a program code for performing the above method when the program is executed on a processor.

### Short description of the Figures

Some examples of apparatuses and/or methods will be described in the following by way of example only, and with reference to the accompanying figures, in which
- Fig. 1a: shows a schematic diagram of an example of an ion milling system during ion milling of a sample;
- Fig. 1b: shows a schematic diagram of an example of an ion milling system during observation of a sample;
- Fig. 1c: shows a schematic diagram of an example of a view of a sample, with the view being used to select an area to be milled;
- Fig. 1d: shows a schematic diagram of an example of a view of a sample during irradiation of the sample;
- Fig. 2: shows a flow chart of an example of a method for an ion milling system; and
- Fig. 3: shows a schematic diagram of a system comprising an imaging device and a computer system.

### Detailed Description

Various examples will now be described more fully with reference to the accompanying drawings in which some examples are illustrated. In the figures, the thicknesses of lines, layers and/or regions may be exaggerated for clarity.

The present disclosure relates to ion milling. Ion milling is a technique used to etch or clean the surface of materials using a beam of ions that is emitted by an ion source, such as an argon ion source. Ion milling works by directing a high-energy beam of ions at the surface of a sample. As these ions collide with the atoms at the surface of the material, they effectively sputter away the atoms, gradually eroding the surface. This process is known for its precision and is commonly used in scenarios where traditional mechanical or chemical methods might be too harsh or imprecise.

The technique is widely utilized in the preparation of samples for electron microscopy, where a clean, smooth surface is crucial for accurate imaging. It is also employed in the microelectronics industry for thinning semiconductor samples, enabling detailed analysis.

Additionally, ion milling is used in materials science research, where understanding the composition and structure of materials at the microscopic level is beneficial.

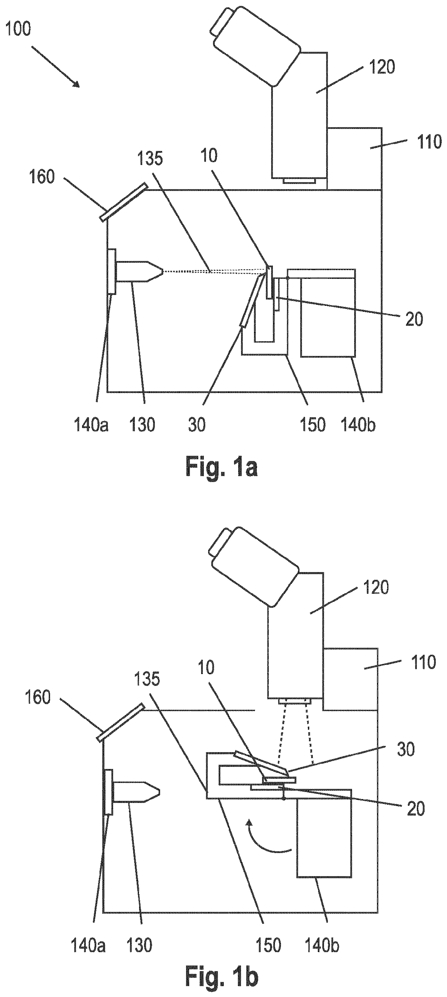

Fig. 1a shows a schematic diagram of an example of an ion milling system 100 during ion milling of a sample 10. An ion milling system 100 typically comprises several components. These include at least one ion emitter 130, which comprises the ion source that generates the ion beam (commonly using Argon gas) and ion optics, which are used to direct the beam 135 onto the sample 10. A mechanical ion beam positioning system 140a is used to target the sample by adjusting at least one of a lateral position, vertical position, or orientation of the at least one ion emitter 130.

A sample stage 150 holds and precisely positions the sample during processing. The sample 10 is attached to a sample holder 20, which is mounted to the sample stage 150. A mask 30 partially shields the sample 10 during ion milling. A mechanical sample stage positioning system 140b is used to position the sample stage 150 with the sample 10 relative to the ion beam 135, with the mechanical sample stage positioning system 140b being configured to adjust at least one of a lateral position, vertical position, or orientation of the sample stage 150, and therefore of the sample 10. The ion milling system 100 may also use vacuum equipment to maintain a controlled environment, which is useful for reducing or minimizing contamination and ensuring consistent results. Finally, a control system 110 controls the operation and parameters of the ion milling process, allowing for adjustments to be made for different applications and material types. The control system 110 can be controlled via a touch-screen display 160, which is coupled to the control system 110.

In the ion milling system 100 shown in Figs. 1a to 1d, a digital or hybrid microscope 120 allows a user to inspect the sample 10 that is placed on the sample stage 150. The control system 110 uses image data from the microscope 120, which performs the function of an imaging device. Alternatively, a camera may be placed in the chamber of the ion milling system 100 and be used to monitor the sample before and after the ion milling. As the sputtering leads to deposition of material removed from the sample on the components inside the ion milling chamber, the camera may be shielded from the sample chamber during ion milling, e.g., using a retractable shield, which may be removed periodically or occasionally to allow for monitoring of the progress of the ion milling process.

The proposed concept relates to visual programming of the ion milling system 100. A user is provided with a software tool that allows the user to define the area to be milled, e.g., by defining the dimensions of the milling crater (e.g., as a diameter for flat milling, or width and depth for cross-section mode). The software tool subsequently sets the required parameters to execute the process accordingly, so that the user can efficiently process the sample without the risk of human error.

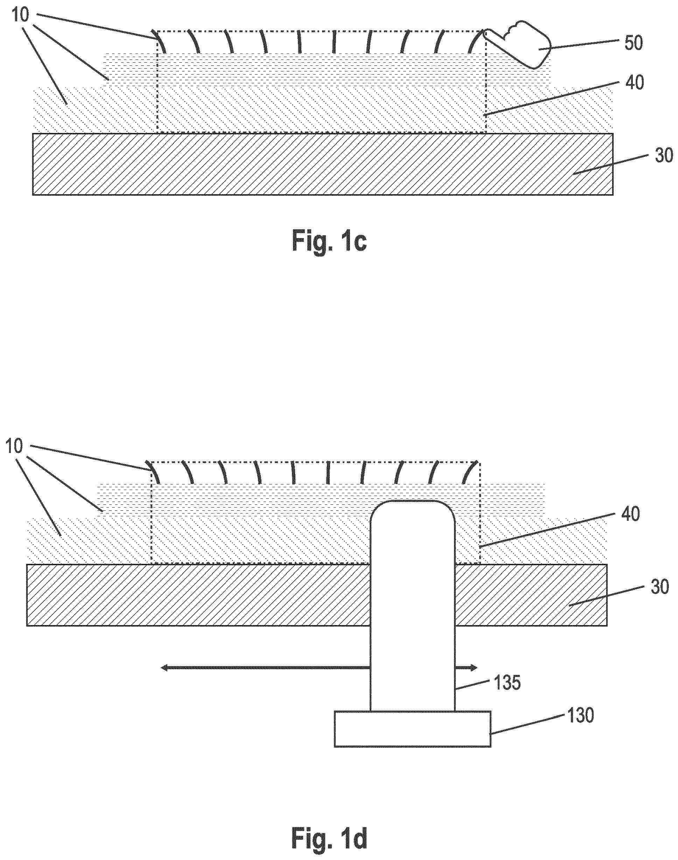

In the proposed concept, the area to be processed can be programmed visually, e.g., as shown by the rectangular outline 40 in Figs. 1c and 1d. In the proposed concept, an imaging device (camera, microscope 120) observes the sample, with the image data of the imaging device being calibrated (pixels in µm). The position of the image is referenced to the source and mask. In a graphic overlay shown in a user interface, the user can define the area that is to be exposed and etched/polished using the ion milling system 100.

Thus, the control system 110 uses the image data of the microscope 120 or camera to aid the user in selecting an area of the sample to be milled. Accordingly, the control system 110 is configured to obtain image data from an imaging device, e.g., the microscope 120 or the camera, of the ion milling system 100. The image data shows a sample 10 to be milled using ions emitted by at least one ion emitter 130 of the ion milling system 100. Depending on where the imaging device is placed, the image data can be obtained in situ, i.e., while the sample is arranged opposite the at least one ion emitter 130, or, as shown in Fig. 1b, the sample stage may be moved (e.g., tilted) towards the imaging device for observation. Fig. 1b shows a schematic diagram of an example of an ion milling system 100 during observation of a sample, when using the microscope 120 as the imaging device. To allow for observation of the sample, the sample stage is tilted upwards by 90 degrees, such that the ion emitter-facing side of the sample now faces towards the microscope 120. As the sample is partially shielded by the mask 30, the image data further shows the mask 30 for shielding a further portion of the sample 10.

The control system 110 displays the image data, showing the sample and mask, to the user as part of a user interface. The control system 110 is configured to generate a digital view of the sample based on the image data. In other words, the control system 110 is configured to generate an image to be included in the user interface, with the image showing the sample (and mask). The control system 110 then provides a user interface for a display device, such as the touch screen 160, with the user interface comprising the view of the sample. This user interface is used not only to show the sample (and mask), including the alignment between mask and sample, to the user, but also to enable the user to visually select a portion of the sample that is to be milled by the ion milling system 100. For this purpose, the user interface is provided with an input mechanism for selecting a portion of the sample using a pointing device. In this context, a pointing device is an input hardware component used to interact with and control a computer's user interface by moving a cursor or pointer on the screen. Common examples include a touch screen, trackpad, mouse, and trackball. For example, the control system 110 may be configured to provide the user interface for the touch screen 160 of the ion milling system 100, and to obtain the user input via the touch screen. In this example, the finger of the user interacts with the pointing device, as the finger is sensed by the touch screen 160. Alternatively, or additionally, the control system 110 may be configured to provide the user interface via a computer system of the ion milling system 100. For example, the control system 110 may be a computer system that can be controlled using input peripherals. In this case, the control system 110 may be configured to obtain the user input via a mouse, trackpad or trackball of the computer system (with the mouse, trackpad or trackball being the pointing device in this case). Additionally, or alternatively, the user interface may be provided for a client device. In other words, the control system 110 may be configured to provide the user interface for a client device via a computer network, and to obtain the user input via the client device. For example, the user interface may be provided for an internet browser or application of the client device, for instance as a web application.

Various input mechanisms that are suitable for selecting a portion of the sample that is to be milled in the view of the sample may be used with such pointing devices. For example, a click and drag input mechanism may be used, in which a user can click on one point in the view and drag (while holding down the pointing device, e.g., the mouse button) to another point to create a rectangular (or freeform) selection, e.g., akin to using a Marquee tool. Alternatively, the user may click a first time to define one corner and click a second time to define another corner, with a rectangle being defined between the two corners. Thus, the control system 110 may be configured to provide the user interface with an input mechanism that is operable for selecting a rectangular portion of the sample using the pointing device (e.g., using the click and drag operation or the two-click operation). There are other input mechanisms for selecting an area of the sample by selecting an enclosed two-dimensional portion of the view of the sample. For example, a lasso tool may be used to draw a freehand shape around the area to be milled by clicking/dragging repeatedly using the pointing device. Alternatively, or additionally, a magic wand tool may be used to automatically select areas based on color similarity, allowing users to click within the view to select contiguous regions of similar colors. Thus, in general terms, the control system 110 may be configured to provide the user interface with an input mechanism that is operable for selecting an enclosed two-dimensional portion of the view of the sample. The control system 110 is configured to obtain user input related to the selection of the portion of the sample, via the input mechanism of the user interface. For example, the control system 110 may be configured to obtain coordinates of the selected area via/from the user interface.

In Figs. 1c and 1d, an example is provided in which a rectangular portion 40 of the sample 10 is selected using a click and drag operation. Fig. 1c shows a schematic diagram of an example of a view of a sample 10, with the view being used to select an area to be milled. In Figs. 1c and 1d, the sample 10 is an integrated circuit, comprising a lower section having a larger width, an upper section having a smaller width, and wire bonds that are shown on top. The sample is partially hidden by the mask 30, which is arranged between the sample and the at least one ion emitter 130. The user clicks and drags a pointing device 50 (e.g., a finger on a touchscreen, a mouse) across the user interface to select a rectangular portion 40 of the view of the sample, and thus the area to be milled.

Fig. 1d shows a schematic diagram of an example of a (simulated) view of the sample 10 during irradiation of the sample 10 by an ion beam 135 of the ion emitter 130. The ion beam 135 sequentially targets different portions of the selected area 40, as the sample stage 150 and ion emitter 130 are moved relative to each other. For example, the control system 110 may be configured to adjust the milling time and stage movement (e.g., of the sample stage 150 and/or the ion emitter 130, using the respective mechanical positioning systems 140a, and 140b) to process the selected area.

The control system 110 is configured to control the area to be milled using the ions emitted by at least one ion emitter 130 based on the portion of the sample (e.g., portion of the view of the sample) selected by the user. For this purpose, the control system 110 translates the user's input into stage movement parameters, taking into account the properties of the ion source, so that the defined area is exposed after the process has been completed. Thus, the control system 110 may be configured to control the mechanical positioning system 140a, 140b configured to adjust at least one of the lateral position, vertical position, or orientation of the at least one ion emitter 130 or of the sample stage 150 (based on the stage movement parameters) to control the area to be milled.

For this purpose, the control system 110 may be configured to map the selected portion (i.e., pixels) of the view to real-world coordinates using a known transformation between the pixels and the real-world coordinate system. The control system 110 may then compute the required displacement of the sample stage 150 or ion emitter 130 so that a portion of the selected area aligns with the emission axis of the ion emitter 130. Thus, the control system 110 may be configured to control the mechanical positioning system based on a pre-defined relationship between pixels of the image data and a corresponding lateral position, vertical position, and/or orientation of the at least one ion emitter or of the sample stage. As outlined above, this may be a two-part transformation between pixels and the corresponding lateral position, vertical position, and/or orientation by first computing the coordinates of the area in the real-world coordinate system and then computing the required vertical, lateral, or angular displacement required for targeting the area using the ion beam. Both computations are based on the aforementioned pre-defined relationship between pixels and real-world coordinates.

In many cases, the ion beam is not wide enough and does not have the same intensity over its width, so that the entire area cannot be irradiated without moving the ion emitter 130 and sample stage 150 relative to each other. Instead, a milling path may be defined that specifies a relative movement between the ion emitter 130 and sample stage 150 (in most cases by moving the sample stage). In other words, the control system 110 may be configured to determine a milling path based on the portion of the sample selected by the user. The milling path indicates a sequence of adjustments to the lateral position, vertical position, and/or orientation of the at least one ion emitter or of the sample stage based on the portion of the sample selected by the user. To determine a milling path for uniform material removal in ion milling, a systematic raster pattern (e.g., a grid-based pattern or a serpentine pattern) may be used in the milling path to ensure even beam distribution across the defined area. The milling path may be chosen so that the entire area receives the same amount of ion beam irradiation, which depends on the spatial distribution of the ions in the ion beam.

In general, as shown in Figs. 1a and 1d, an ion beam has a certain width as the beam expands as it gains distance from the ion emitter 130. The width of the ion beam, as the ion beam hits the sample, depends, among other factors, on the characteristics of the ion source and focusing system (e.g., aperture size, divergence angle, lens settings, electric/magnetic fields, etc.), kinetic energy of the ions (caused by the acceleration voltage), and working distance. The highest concentration of ions hits the sample towards the center of the ion beam, with the ion concentration dropping off rapidly, resulting in a Gaussian distribution of the ion beam. This distribution, which can primarily be influenced, at runtime, by setting the kinetic energy of the ions, may be taken into account when determining the stage movement parameters based on the selected portion of the view. In particular, the kinetic energy of the ions emitted, and the spatial distribution of the ions, determines how much radiation is received by a given portion of the sample, and thus how much material is removed. To ensure that the entire area receives the same amount of ion beam irradiation, the spatial distribution of the ions in the ion beam (which is influenced by the acceleration voltage and resulting kinetic energy of the ions) may be taken into account when programming the milling path, selecting the overlap between adjacent passes such that the drop-off in intensity is compensated for by the overlap with the adjacent pass. In more general terms, the control system 110 may be configured to determine the milling path based on a spatial distribution of ions within the ion beam and/or based on a kinetic energy of the ions emitted by the ion emitter.

Another factor to consider when determining the milling path is the desired depth of material to be removed. For example, the control system 110 may be configured to determine the milling path further based on a desired depth of material to be removed by the ion milling. In particular, the control system 110 may be configured to control a number of passes or a dwell time/scanning speed based on the depth of material to be removed.

In general, the mask is used to shield some portions of the sample (and the sample stage). To avoid wasting energy and time, and to avoid wearing out the mask, the control system 110 may be configured to exclude the mask from the area to be milled. However, due to the width of the ion beam, the mask will still be hit by off-center portions of the ion beam.

In some examples, the control system 110 may be configured to independently recognize and monitor whether the area has actually been exposed as desired. This can be done by (periodically or occasionally) analyzing further image data to determine whether the material removed from the sample matches the milling path. For example, the control system 110 may be configured to obtain further image data from the imaging device, with the image data showing the progress of the ion milling of the sample. When using the microscope 120 as the imaging device, this can be done by tilting the sample stage upwards (e.g., using a motorized tilting mechanism) and generating the further image data using the optical imaging sensor of the microscope 120. If a camera is used that is located within the chamber, the camera's shield may be temporarily removed to obtain the further image data. The control system 110 may be configured to determine a match or mismatch between the milling path and the material removed from the sample by comparing the image data and the further image data. Based on this analysis, the control system 110 may either maintain the milling path or adjust the milling path (e.g., to adjust for a drift or misalignment visible in the comparison between the image data and the further image data). In other words, the control system 110 may be configured to maintain or adjust the milling path based on the progress of the ion milling of the sample shown in the further image data.

The proposed concept allows the user to define the etching area quickly and efficiently without requiring in-depth knowledge of the control system 110. The user receives direct visual feedback on the settings via the rectangular frame 40 and can therefore immediately see whether the instrument has been successfully programmed. This increases the success rate and avoids excessively long processing of the sample, thereby saving time.

In general, the control system 110 may be a computer system. The control system 110 comprises one or more processors 114 and one or more storage devices 116. Optionally, the control system 110 further comprises one or more interfaces 112. The one or more processors 114 are coupled to the one or more storage devices 116 and to the one or more interfaces 112. In general, the functionality of the control system 110 may be provided by the one or more processors 114, in conjunction with the one or more interfaces 112 (for exchanging data/information with one or more other components of the ion milling system 100 and outside the ion milling system 100, such as an the imaging device 120, the ion emitter 130, the mechanical positioning device(s) 140a, 140b, and/or the touch-screen display 160), and with the one or more storage devices 116 (for storing information, such as machine-readable instructions of a computer program being executed by the one or more processors). In general, the functionality of the one or more processors 114 may be implemented by the one or more processors 114 executing machine-readable instructions. Accordingly, any feature ascribed to the one or more processors 114 may be defined by one or more instructions of a plurality of machine-readable instructions. The control system 110 may comprise the machine-readable instructions, e.g., within the one or more storage devices 116.

The control system 110 is configured to provide a user interface showing the sample. For example, the control system 110 may be configured to output a display signal to a touch-screen display 160 or a display 160 of the ion milling system 100, with the display signal comprising the user interface. For example, the display signal may be a signal for driving (e.g., controlling) the respective display. For example, the display signal may comprise video data and/or control instructions for driving the display. For example, the display signal may be provided via one of the one or more interfaces 112 of the control system 110. Accordingly, the control system 110 may comprise a video interface 112 that is suitable for providing the display signal to the display device 160 of the ion milling system 100.

In the proposed ion milling system 100, optical imaging sensor(s) of the imaging device 120 are used to provide the aforementioned image data. Accordingly, the optical imaging sensor(s), which may be part of the imaging device 120 (e.g., of the microscope or camera), may be configured to generate the image data. For example, the optical imaging sensor(s) of the imaging device 120 or camera may comprise or be an APS (Active Pixel Sensor)-based imaging sensor or a CCD (Charge-Coupled-Device)-based imaging sensor. For example, in APS-based imaging sensors, light is recorded at each pixel using a photodetector and an active amplifier of the pixel. APS-based imaging sensors are often based on CMOS (Complementary Metal-Oxide-Semiconductor) or S-CMOS (Scientific CMOS) technology. In CCD-based imaging sensors, incoming photons are converted into electron charges at a semiconductor-oxide interface, which are subsequently moved between capacitive bins in the imaging sensor by circuitry of the imaging sensor to perform the imaging. For example, the control system 110 may be configured to obtain the image data from the imaging device 120, for instance, by receiving the image data from the imaging device 120 or by reading out the image data from the imaging device 120.

The one or more interfaces 112 of the control system 110 may correspond to one or more inputs and/or outputs for receiving and/or transmitting information, which may be in digital (bit) values according to a specified code, within a module, between modules or between modules of different entities. For example, the one or more interfaces 112 may comprise interface circuitry configured to receive and/or transmit information. The one or more processors 114 of the control system 110 may be implemented using one or more processing units, one or more processing devices, any means for processing, such as a processor, a computer or a programmable hardware component being operable with accordingly adapted software. In other words, the described function of the one or more processors 114 may as well be implemented in software, which is then executed on one or more programmable hardware components. Such hardware components may comprise a general-purpose processor, a Digital Signal Processor (DSP), a micro-controller, etc. The one or more storage devices 116 of the control system 110 may comprise at least one element of the group of a computer readable storage medium, such as a magnetic or optical storage medium, e.g., a hard disk drive, a flash memory, Floppy-Disk, Random Access Memory (RAM), Programmable Read Only Memory (PROM), Erasable Programmable Read Only Memory (EPROM), an Electronically Erasable Programmable Read Only Memory (EEPROM), or a network storage.

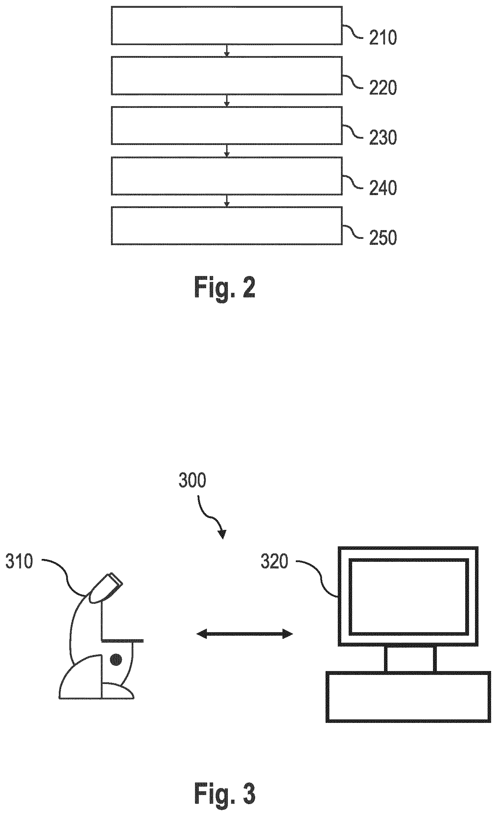

More details and aspects of the ion milling system 100 and the control system 110 are mentioned in connection with the proposed concept or one or more examples described above or below (e.g., Figs. 2 to 3). The ion milling system 100 and the control system 110 may comprise one or more additional optional features corresponding to one or more aspects of the proposed concept or one or more examples described above or below.

Fig. 2 shows a flow chart of an example of a corresponding method for an ion milling system, such as the ion milling system 100 of Figs. 1a to 1d. For example, the method may be performed by the control system 110 of Figs. 1a and/or 1b. Features discussed in connection with the control system 110 and/or ion milling system 100 of Figs. 1a to 1d may likewise be included in the corresponding method of Fig. 2.

The method comprises obtaining 210 image data of an imaging device of the ion milling system 100. The image data shows a sample to be milled using ions emitted by at least one ion emitter of the ion milling system 100. The method comprises generating 220 a view of the sample based on the image data. The method comprises providing 230 a user interface for a display device. The user interface comprises the view of the sample. The user interface comprises an input mechanism for selecting a portion of the sample using a pointing device. The method comprises obtaining 240 a user input related to the selection of the portion of the sample. The method comprises controlling 250 an area to be milled using the ions emitted by at least one ion emitter based on the portion of the sample selected by the user.

More details and aspects of the method are mentioned in connection with the proposed concept or one or more examples described above or below (e.g. Figs. 1a to 1d, and 3). The method may comprise one or more additional optional features corresponding to one or more aspects of the proposed concept or one or more examples described above or below.

As used herein the term "and/or" includes any and all combinations of one or more of the associated listed items and may be abbreviated as "/".

Although some aspects have been described in the context of an apparatus, it is clear that these aspects also represent a description of the corresponding method, where a block or device corresponds to a method step or a feature of a method step. Analogously, aspects described in the context of a method step also represent a description of a corresponding block or item or feature of a corresponding apparatus.

Some embodiments relate to an imaging device that is part of a system as described in connection with one or more of the Figs. 1a to 2. Fig. 3 shows a schematic illustration of a system 300 configured to perform a method described herein. The system 300 comprises an imaging device 310 and a computer system 320. The imaging device 310 is configured to take images and is connected to the computer system 320. The computer system 320 is configured to execute at least a part of a method described herein. The computer system 320 may be configured to execute a machine learning algorithm. The computer system 320 and imaging device 310 may be separate entities but can also be integrated together in one common housing. The computer system 320 may be part of a central processing system of the imaging device 310 and/or the computer system 320 may be part of a subcomponent of the imaging device 310, such as a sensor, an actor, a camera or an illumination unit, etc. of the imaging device 310.

The computer system 320 may be a local computer device (e.g. personal computer, laptop, tablet computer or mobile phone) with one or more processors and one or more storage devices or may be a distributed computer system (e.g. a cloud computing system with one or more processors and one or more storage devices distributed at various locations, for example, at a local client and/or one or more remote server farms and/or data centers). The computer system 320 may comprise any circuit or combination of circuits. In one embodiment, the computer system 320 may include one or more processors which can be of any type. As used herein, processor may mean any type of computational circuit, such as but not limited to a microprocessor, a microcontroller, a complex instruction set computing (CISC) microprocessor, a reduced instruction set computing (RISC) microprocessor, a very long instruction word (VLIW) microprocessor, a graphics processor, a digital signal processor (DSP), multiple core processor, a field programmable gate array (FPGA), for example, of a imaging device or a imaging device component (e.g. camera) or any other type of processor or processing circuit. Other types of circuits that may be included in the computer system 320 may be a custom circuit, an application-specific integrated circuit (ASIC), or the like, such as, for example, one or more circuits (such as a communication circuit) for use in wireless devices like mobile telephones, tablet computers, laptop computers, two-way radios, and similar electronic systems. The computer system 320 may include one or more storage devices, which may include one or more memory elements suitable to the particular application, such as a main memory in the form of random access memory (RAM), one or more hard drives, and/or one or more drives that handle removable media such as compact disks (CD), flash memory cards, digital video disk (DVD), and the like. The computer system 320 may also include a display device, one or more speakers, and a keyboard and/or controller, which can include a mouse, trackball, touch screen, voice-recognition device, or any other device that permits a system user to input information into and receive information from the computer system 320.

Some or all of the method steps may be executed by (or using) a hardware apparatus, like for example, a processor, a microprocessor, a programmable computer or an electronic circuit. In some embodiments, some one or more of the most important method steps may be executed by such an apparatus.

Depending on certain implementation requirements, embodiments of the invention can be implemented in hardware or in software. The implementation can be performed using a non-transitory storage medium such as a digital storage medium, for example a floppy disc, a DVD, a Blu-Ray, a CD, a ROM, a PROM, and EPROM, an EEPROM or a FLASH memory, having electronically readable control signals stored thereon, which cooperate (or are capable of cooperating) with a programmable computer system such that the respective method is performed. Therefore, the digital storage medium may be computer readable.

Some embodiments according to the invention comprise a data carrier having electronically readable control signals, which are capable of cooperating with a programmable computer system, such that one of the methods described herein is performed.

Generally, embodiments of the present invention can be implemented as a computer program product with a program code, the program code being operative for performing one of the methods when the computer program product runs on a computer. The program code may, for example, be stored on a machine readable carrier.

Other embodiments comprise the computer program for performing one of the methods described herein, stored on a machine readable carrier.

In other words, an embodiment of the present invention is, therefore, a computer program having a program code for performing one of the methods described herein, when the computer program runs on a computer.

A further embodiment of the present invention is, therefore, a storage medium (or a data carrier, or a computer-readable medium) comprising, stored thereon, the computer program for performing one of the methods described herein when it is performed by a processor. The data carrier, the digital storage medium or the recorded medium are typically tangible and/or non-transitionary. A further embodiment of the present invention is an apparatus as described herein comprising a processor and the storage medium.

A further embodiment of the invention is, therefore, a data stream or a sequence of signals representing the computer program for performing one of the methods described herein. The data stream or the sequence of signals may, for example, be configured to be transferred via a data communication connection, for example, via the internet.

A further embodiment comprises a processing means, for example, a computer or a programmable logic device, configured to, or adapted to, perform one of the methods described herein.

A further embodiment comprises a computer having installed thereon the computer program for performing one of the methods described herein.

A further embodiment according to the invention comprises an apparatus or a system configured to transfer (for example, electronically or optically) a computer program for performing one of the methods described herein to a receiver. The receiver may, for example, be a computer, a mobile device, a memory device or the like. The apparatus or system may, for example, comprise a file server for transferring the computer program to the receiver.

In some embodiments, a programmable logic device (for example, a field programmable gate array) may be used to perform some or all the functionalities of the methods described herein. In some embodiments, a field programmable gate array may cooperate with a microprocessor to perform one of the methods described herein. Generally, the methods are preferably performed by any hardware apparatus.

### List of reference Signs

- 10:: Sample
- 20:: Sample holder
- 30:: Mask
- 40:: Selected portion of the sample (e.g., rectangular outline)
- 50:: Pointing device
- 100:: Ion milling system
- 110:: Control system
- 112:: Interface
- 114:: Processor
- 116:: Storage device
- 120:: Microscope (imaging device)
- 130:: Ion emitter (ion source)
- 135:: Ion beam
- 140a:: Mechanical ion beam positioning system
- 140b:: Mechanical sample stage positioning system
- 150:: Sample stage
- 160:: Touch-screen display (display device)
- 210:: Obtaining image data
- 220:: Generating a view of the sample
- 230:: Providing a user interface
- 240:: Obtaining a user input
- 250:: Controlling the area to be milled
- 300:: System
- 310:: Imaging device
- 320:: Computer system

## Claims

1. A control system (110) for an ion milling system (100), the control system comprising one or more processors and one or more storage devices, wherein the control system is configured to:
obtain image data of an imaging device (120) of the ion milling system, the image data showing a sample (10) to be milled using ions emitted by at least one ion emitter (130) of the ion milling system;
generate a view of the sample based on the image data;
provide a user interface for a display device, the user interface comprising the view of the sample, with the user interface comprising an input mechanism for selecting a portion of the sample using a pointing device;
obtain a user input related to the selection (40) of the portion of the sample;
control an area to be milled using the ions emitted by at least one ion emitter based on the portion of the sample selected by the user.

2. The control system according to claim 1, wherein the control system is configured to provide the user interface with an input mechanism that is operable for selecting a rectangular portion of the sample using the pointing device.

3. The control system according to claim 1, wherein the control system is configured to provide the user interface with an input mechanism that is operable for selecting an enclosed two-dimensional portion of the view of the sample.

4. The control system according to one of the claims 1 to 3, wherein the control system is configured to control a mechanical positioning system (140a, 140b) configured to adjust at least one of a lateral position, vertical position, or orientation of the at least one ion emitter (130) or of a sample stage (150) hosting the sample to control the area to be milled.

5. The control system according to claim 4, wherein the control system is configured to control the mechanical positioning system based on a pre-defined relationship between pixels of the image data and a corresponding lateral position, vertical position and/or orientation of the at least one ion emitter or of the sample stage.

6. The control system according to one of the claims 4 to 6, wherein the control system is configured to determine a milling path based on the portion of the sample selected by the user, with the milling path indicating a sequence of adjustments to the lateral position, vertical position and/or orientation of the at least one ion emitter or of the sample stage based on the portion of the sample selected by the user.

7. The control system according to claim 6, wherein the control system is configured to determine the milling path based on a spatial distribution of ions within the ion beam and/or based on a kinetic energy of the ions emitted by the ion emitter.

8. The control system according to one of the claims 6 or 7, wherein the control system is configured to determine the milling path further based on a desired depth of material to be removed by the ion milling.

9. The control system according to one of the claims 7 or 8, wherein the control system is configured to obtain further image data of the imaging device, the image data showing a progress of the ion milling of the sample, and to maintain or adjust the milling path based on the progress of the ion milling of the sample shown in the further image data.

10. The control system according to one of the claims 1 to 9, wherein the image data further shows a mask (30) for shielding a further portion of the sample (10), with the user interface comprising a view of the mask and on the sample.

11. The control system according to one of the claims 1 to 10, wherein the control system is configured to exclude the mask from the area to be milled.

12. The control system according to one of the claims 1 to 11, wherein the control system is configured to provide the user interface for a touch screen of the ion milling system, and to obtain the user input via the touch screen,
or wherein the control system is configured to provide the user interface via a computer system of the ion milling system, and to obtain the user input via a mouse, trackpad or trackball of the computer system,
or wherein the control system is configured to provide the user interface for a client device via a computer network, and to obtain the user input via the client device.

13. An ion milling system (100) comprising the control system (110) according to one of the claims 1 to 12, an imaging device (120), and at least one ion emitter (130).

14. A method for controlling an ion milling system, the method comprising:
obtaining (210) image data of an imaging device of the ion milling system, the image data showing a sample to be milled using ions emitted by at least one ion emitter of the ion milling system;
generating (220) a view of the sample based on the image data;
providing (230) a user interface for a display device, the user interface comprising the view of the sample, with the user interface comprising an input mechanism for selecting a portion of the sample using a pointing device;
obtaining (240) a user input related to the selection of the portion of the sample;
controlling (250) an area to be milled using the ions emitted by at least one ion emitter based on the portion of the sample selected by the user.

15. A computer program having a program code for performing the method according to claim 14 when the program is executed on a processor.
